# FASCICULE DE BREVET EUROPEEN

(11) **EP 3 109 200 B1**
(45) Date de publication et mention de la délivrance du brevet: **28.06.2023**
(21) Numéro de dépôt: 16170650.2
(22) Date de dépôt: 20.05.2016
(51) Int. Cl.: G04B 13/02

(54) **PIECE DE MICROMECANIQUE AVEC UNE SURFACE DE CONTACT DIMINUEE ET SON PROCEDE DE FABRICATION**
MIKROMECHANISCHES TEIL MIT VERKLEINERTER KONTAKTFLÄCHE, UND SEIN HERSTELLUNGSVERFAHREN
MICROMECHANICAL PART WITH REDUCED CONTACT SURFACE AND METHOD FOR MANUFACTURING SAME

(30) Priorité: 25.06.2015 EP 15173825
(43) Date de publication de la demande: 28.12.2016
(73) Titulaire: Nivarox-FAR S.A., 2400 Le Locle (CH)
(72) Inventeur: Gandelhman, Alex, 2000 Neuchâtel (CH); Pin, André, 2525 Le Landeron (CH)
(74) Mandataire: Collé, Emmanuel

(56) Documents cités:
- EP-A1- 2 120 105
- EP-A1- 2 735 540
- EP-A1- 2 840 059
- CH-A2- 699 476
- CN-B- 102 838 079
- US-A- 6 150 275
- US-B1- 6 406 636

## Description

### Domaine de l'invention

L'invention se rapporte à une pièce de micromécanique avec une surface de contact diminuée et son procédé de fabrication. Plus particulièrement, l'invention se rapporte à une telle pièce formée par micro-usinage d'une plaquette de matière.

### Arrière-plan de l'invention

Le document CH 698 837 divulgue la fabrication d'un composant horloger par micro-usinage d'une plaquette en matériau amorphe ou cristallin tel que du silicium sous forme cristalline ou polycristalline.

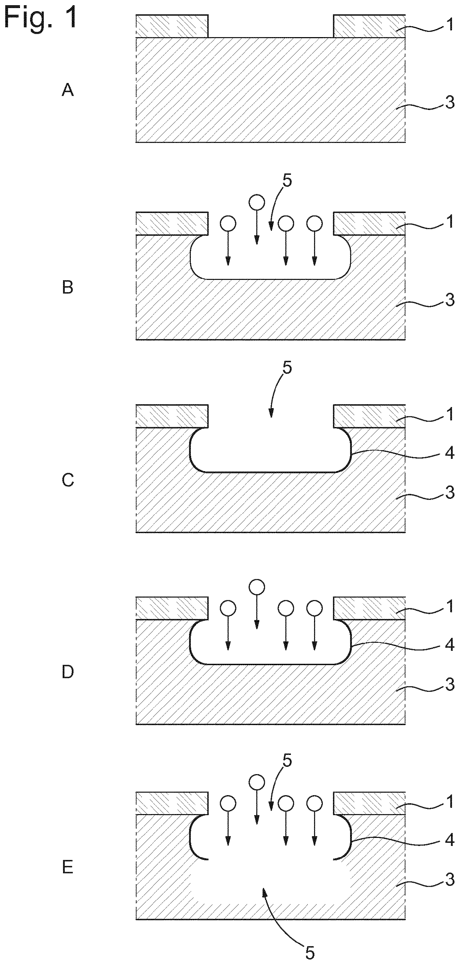

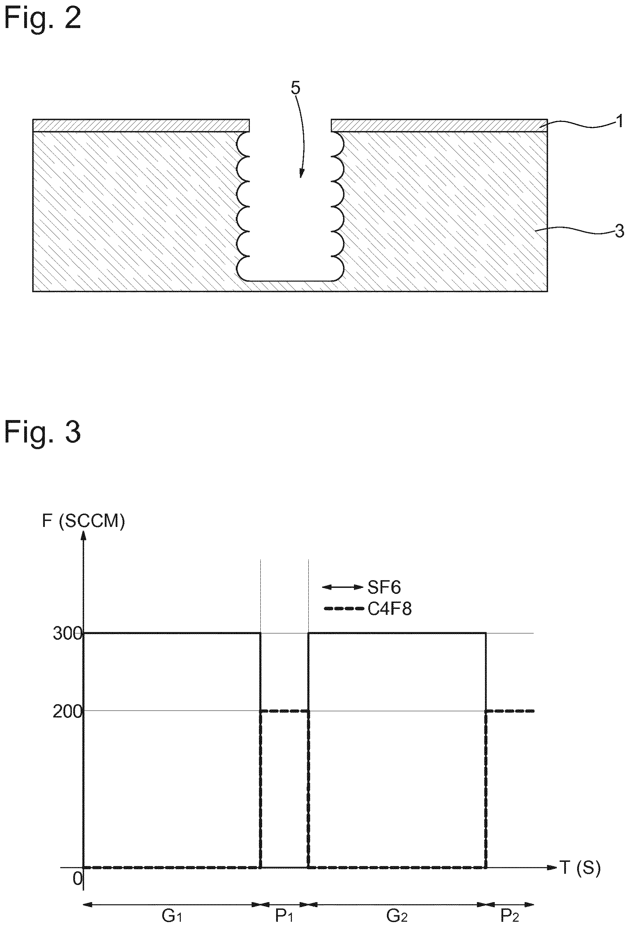

Un tel micro-usinage est généralement obtenu à partir d'un gravage ionique réactif profond (connu également sous l'abréviation anglaise « DRIE »). Comme illustré aux figures 1 à 3, un micro-usinage connu consiste en une structuration d'un masque 1 sur un substrat 3 (cf. Figure 1, étape A) suivi d'un gravage ionique réactif profond du type « Bosch » combinant successivement une phase d'attaque (cf. figure 1, étapes B, D, E) suivie d'une phase de passivation (cf. figure 1, étape C, couche 4) pour obtenir, à partir du motif du masque 1, d'une gravure anisotrope 5, c'est-à-dire sensiblement verticale, dans la plaquette (cf. figure 2).

Comme illustré à la figure 3, un exemple de gravage ionique réactif profond du type « Bosch » est représenté avec, en trait plein, le flux en SCCM de SF₆ en fonction du temps en secondes permettant le gravage d'une plaquette en silicium et, en trait interrompu, le flux en SCCM de C₄F₈ en fonction du temps en secondes permettant la passivation, c'est-à-dire la protection, de la plaquette en silicium. On peut ainsi très bien voir que les phases sont strictement consécutives et comportent un flux et un temps qui leur sont propres.

Dans l'exemple de la figure 3, une première phase G₁ de gravage est représentée avec un flux de SF₆ à 300 SCCM pendant 7 secondes, suivie par une première phase P₁ de passivation avec un flux de C₄F₈ à 200 SCCM pendant 2 secondes, suivie d'une deuxième phase G₂ de gravage avec un flux de SF₆ à 300 SCCM à nouveau pendant 7 secondes et, enfin, suivie d'une deuxième phase P₂ de passivation avec un flux de C₄F₈ à 200 SCCM pendant 2 secondes, et ainsi de suite. On remarque donc qu'un certain nombre de paramètres permet de faire varier le gravage ionique réactif profond du type « Bosch » pour avoir une ondulation plus ou moins marquée de la paroi de la gravure verticale 5.

Après plusieurs années de fabrication, il s'est avéré que ces gravures 5 verticales n'étaient pas totalement satisfaisantes notamment au niveau tribologique.

Le document EP 2840 059 décrit une pièce de micromécanique en silicium comprenant un angle entre la surface verticale et la surface oblique inférieur à 10°.

Le document US 6 150 275 décrit un système micromécanique comprenant une succession de parois verticale, horizontale et oblique intérieures arrangées dans un corps en silicium.

### Résumé de l'invention

Le but de la présente invention est de pallier tout ou partie les inconvénients cités précédemment en proposant un nouveau type de pièce de micromécanique et un nouveau type de procédé de fabrication permettant notamment l'amélioration tribologique de pièces formées par micro-usinage d'une plaquette de matière.

A cet effet, l'invention se rapporte à un procédé de fabrication d'une pièce de micromécanique à base de silicium selon la revendication 1.

On comprend que, dans la même chambre de gravage, deux types distincts de gravage sont obtenus. On comprend immédiatement que le gravage oblique de l'étape e) permet de former une deuxième surface sensiblement oblique pour former plusieurs pièces de micromécanique sur le même substrat ayant une paroi périphérique à surface de contact réduite. On peut également s'apercevoir que, grâce à la couche de protection uniquement sur les parois verticales, le gravage oblique de l'étape e) autorise un angle largement plus ouvert et une direction de gravure sensiblement rectiligne qui évite d'être limité par les paramètres d'un gravage ionique réactif profond du type « Bosch » qui est, en revanche, utilisé lors de l'étape c) selon ses paramètres optimisés de gravure verticale.

Conformément à d'autres variantes avantageuses de l'invention :
- l'étape c) est réalisée en alternant un flux de gaz de gravage et un flux de gaz de passivation dans la chambre de gravage afin de former des parois sensiblement verticales ;
- l'étape d) comporte les phases d1) : oxyder la gravure obtenue lors de l'étape c) pour former la couche de protection en oxyde de silicium et d2) : graver de manière directionnelle la couche de protection afin de retirer sélectivement la partie de couche de protection uniquement au niveau du fond de la gravure de l'étape c) ;

De plus, l'invention se rapporte à une pièce de micromécanique obtenue à partir du procédé selon l'une des variantes précédentes, selon la revendication 4.

Avantageusement selon l'invention, on comprend que la paroi périphérique ou interne verticale de la pièce de micromécanique offre une réduction de sa surface de contact ou quant à l'entrée d'un organe le long d'une paroi interne de la pièce de micromécanique permettant d'apporter une amélioration quant à la tribologie contre une autre pièce.

Conformément à d'autres variantes avantageuses de l'invention :
- la pièce de micromécanique comporte en outre au moins une cavité comportant une paroi interne comprenant également une première surface sensiblement verticale et une deuxième surface sensiblement oblique ;
- la pièce de micromécanique forme tout ou partie d'un organe de mouvement ou d'habillage d'une pièce d'horlogerie.

### Description sommaire des dessins

D'autres particularités et avantages ressortiront clairement de la description qui en est faite ci-après, à titre indicatif et nullement limitatif, en référence aux dessins annexés, dans lesquels :
- les figures 1 à 3 sont des représentations destinées à expliquer le gravage ionique réactif profond du type « Bosch » utilisé dans le cadre de l'invention ;
- les figures 4 à 10 sont des représentations d'étapes de fabrication d'une pièce de micromécanique de l'invention ;
- la figure 11 est une représentation d'une pièce de micromécanique selon l'invention ;
- la figure 12 est un schéma fonctionnel du procédé de fabrication selon l'invention.

### Description détaillée des modes de réalisation préférés

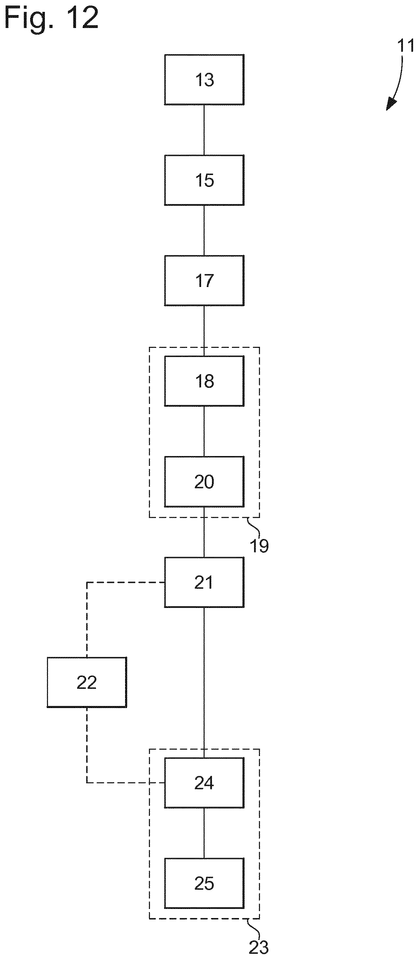

L'invention se rapporte à un procédé 11 de fabrication d'une pièce de micromécanique à base de silicium. Comme illustré à la figure 12, le procédé 11 comporte une première étape 13 destinée à se munir d'un substrat à base de silicium.

Les termes à base de silicium signifient un matériau comportant du silicium monocristallin, du silicium monocristallin dopé, du silicium polycristallin, du silicium polycristallin dopé, du silicium poreux, de l'oxyde de silicium, du quartz, de la silice, du nitrure de silicium ou du carbure de silicium. Bien entendu, quand le matériau à base de silicium est sous phase cristalline, n'importe quelle orientation cristalline peut être utilisée.

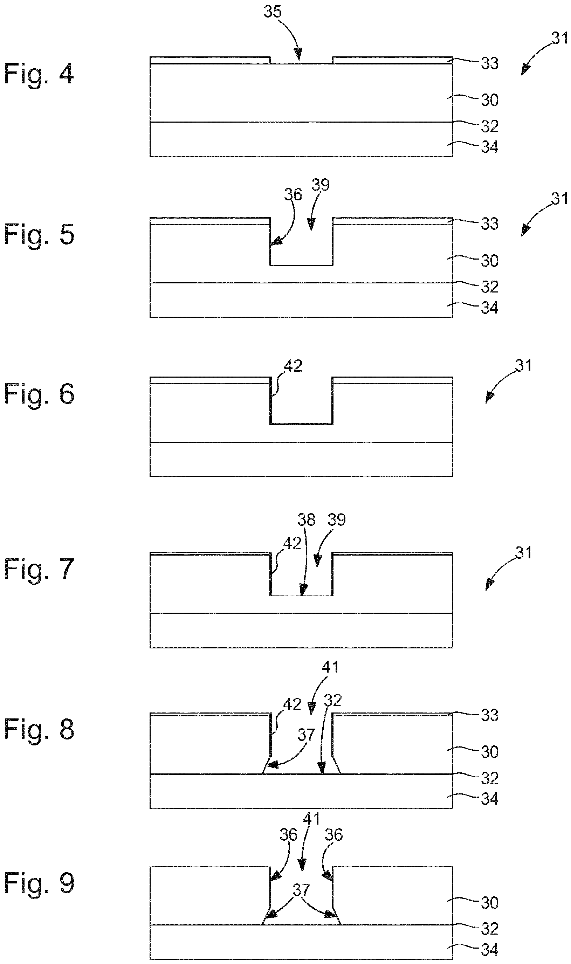

Typiquement, comme illustré à la figure 4, le substrat 31 à base de silicium peut être du silicium sur isolant (également connu sous l'abréviation anglaise « SOI ») comportant une couche supérieure 30 en silicium et une couche inférieure 34 en silicium reliées par une couche intermédiaire 32 en oxyde de silicium. Toutefois, alternativement, le substrat pourrait comporter une couche de silicium rapportée sur une autre type de base comme, par exemple, en métal.

Le procédé se poursuit avec l'étape 15 destinée à former un masque 33 muni d'ajourages 35 sur une partie horizontale du substrat 31. Dans l'exemple de la figure 4, le masque 33 est formé sur la partie supérieure de la couche supérieure 30 en silicium. Le masque 33 est formé à partir d'un matériau capable de résister aux futures étapes de gravage du procédé 11. A ce titre, le masque 33 peut être formé à partir de nitrure de silicium ou d'oxyde de silicium. Dans l'exemple de la figure 4, le masque 33 est formé à partir d'oxyde de silicium.

Avantageusement selon l'invention, le procédé 11 se poursuit avec une étape 17 destinée à graver, dans une chambre de gravage, selon des parois 36 sensiblement verticales, dans au moins une partie de l'épaisseur du substrat 31 à partir des ajourages 35 du masque 33 afin de former des parois périphériques ou internes de la pièce de micromécanique.

L'étape 17 de gravage sensiblement vertical est typiquement un gravage ionique réactif profond du type « Bosch » décrit ci-dessus, c'est-à-dire en alternant un flux de gaz de gravage et un flux de gaz de passivation dans une chambre de gravage afin de former des parois sensiblement verticales 36.

En effet, l'étape 17 autorise une direction de gravure sensiblement verticale par rapport au masque 33 comme visible à la figure 5. On obtient ainsi une gravure 39 dont la section, visible à la figure 5, est sensiblement sous forme d'un quadrilatère droit. Bien entendu, suivant la forme des ajourages 35, la forme du volume enlevé lors du gravage varie. Ainsi, un ajourage circulaire donnera une gravure cylindrique et un ajourage carré, un cube ou un parallélépipède rectangle.

Le procédé 11 se poursuit avec l'étape 19 destinée à former une couche de protection 42 sur les parois verticales 36 en laissant le fond 38 de gravure 39 sans couche de protection comme visible à la figure 7.

Préférentiellement, la couche de protection 42 est formée en oxyde de silicium. En effet, comme visible aux figures 6 et 7, l'étape 19 peut alors comporter une première phase 18 destinée à oxyder tout le dessus du substrat 31, c'est-à-dire le masque 33 (si formé en oxyde de silicium), les parois 36 et le fond 38 formés par la gravure 39 pour former une surépaisseur sur le masque 33 et une épaisseur sur les parois verticales 36 et le fond 38 de la gravure 39 pour former la couche de protection 42 en oxyde de silicium.

La deuxième phase 20 pourrait alors consister à graver, de manière directionnelle, la couche de protection 42 afin de retirer sélectivement les surfaces horizontales en oxyde de silicium d'une partie du masque 33 et de la totalité de la partie de couche de protection 42 uniquement au niveau du fond 38 de la gravure 39 comme visible à la figure 7.

Le procédé 11 peut alors se poursuivre avec l'étape 21 destinée à graver, dans la même chambre de gravage, mais selon des parois obliques 37 prédéterminées, dans le reste de l'épaisseur du substrat 31 à partir du fond 38 sans couche de protection 42 afin de former des surfaces inférieures obliques sous les parois périphériques de la pièce de micromécanique.

L'étape 21 de gravage oblique n'est pas un gravage ionique réactif profond du type « Bosch » décrit ci-dessus. En effet, l'étape 21 autorise, grâce à la couche de protection 42, un angle largement plus ouvert et une direction de gravure sensiblement rectiligne qui évitent d'être limités par les paramètres d'un gravage ionique réactif profond du type « Bosch ». En effet, on estime généralement que, même en modifiant les paramètres d'un gravage ionique réactif profond du type « Bosch », l'angle d'ouverture ne peut excéder 10 degrés en ayant une direction de gravure courbe.

Avantageusement selon l'invention, l'étape 21 est réalisée, préférentiellement, en mélangeant du gaz SF₆ de gravage et du gaz C₄F₈ de passivation dans la chambre de gravage afin de former les parois 37 obliques. Plus précisément, les flux continus des gaz SF₆ de gravage et de passivation C₄F₈ sont pulsés afin de favoriser le gravage en fond de cavité.

On comprend donc l'étape 21 autorise un angle largement plus ouvert typiquement autour de 45 degrés dans l'exemple de la figure 8 au lieu des 10 degrés obtenus au mieux par un gravage ionique réactif profond du type « Bosch » avec une modification optimisée des paramètres. Avantageusement selon l'invention, l'étape 21 permet ainsi de donner un angle d'ouverture précis sans que les surfaces des parois verticales 36 ne soient modifiées. L'angle entre les parois verticales 36 et les parois obliques 37 est très reproductible et peut être avantageusement compris entre sensiblement 0° et sensiblement 45°. Comme expliqué ci-dessus, c'est surtout la possibilité de graver selon un angle supérieur à 10° qui est remarquable par rapport à un gravage ionique réactif profond du type « Bosch ». Préférentiellement, l'angle selon l'invention entre les parois verticales 36 et les parois obliques 37 est supérieur à 10° et inférieur à 45°, et encore plus préféré, supérieur à 20° et inférieur à 40°.

De plus, la pulsation des flux continus autorise une meilleure directivité de gravure, voire obtenir des parois essentiellement en tronc de cônes, et non sphériques (parfois appelés gravures isotropes) comme avec un gravage humide ou un gravage sec comme, par exemple, avec du gaz SF₆ seul.

Pour obtenir la forme de parois 37 de la figure 8, on peut par exemple appliquer une séquence pouvant comporter une première phase avec un flux de SF₆ mélangé avec un flux de C₄F₈ pendant une première durée, suivie par une deuxième phase avec un flux augmenté de SF₆ mélangé avec un flux diminué de C₄F₈ pendant une deuxième durée, puis à nouveau les première et deuxième phases et ainsi de suite.

A titre d'exemple, cette séquence pourrait comporter une première phase avec un flux de SF₆ à 500 SCCM mélangé avec un flux de C₄F₈ à 150 SCCM pendant 1,2 seconde, suivie par une deuxième phase représentée avec un flux de SF₆ à 600 SCCM mélangé avec un flux de C₄F₈ à 100 SCCM pendant 0,8 seconde, suivie d'une troisième phase avec, à nouveau, un flux de SF₆ à 500 SCCM mélangé avec un flux de C₄F₈ à 150 SCCM pendant 1,2 seconde et suivie d'une quatrième phase avec un flux de SF₆ à 600 SCCM mélangé avec un flux de C₄F₈ à 100 SCCM pendant 0,8 seconde et ainsi de suite.

On remarque donc que cette pulsation des flux continus favorise le gravage en fond de cavité ce qui va élargir, au fur et à mesure de l'étape 21, l'ouverture possible de la gravure 41 en fonction de sa profondeur et, incidemment, une ouverture de gravure 41 plus large au niveau de la partie inférieure de la couche supérieure 30 jusqu'à commencer à obtenir une ouverture de gravure 41 plus large que l'ajourage 35 du masque 33 ou de la section du fond 38 de gravure 39 en début d'étape 21 comme visible lors du passage de la figure 7 à la figure 8.

Le procédé 11 se finit avec l'étape 23 destinée à libérer la pièce de micromécanique du substrat 31 et du masque 33. Plus précisément, dans l'exemple présenté aux figures 9 et 12, l'étape 23 peut comporter une phase 24 de désoxydation permettant de retirer le masque 33 en oxyde de silicium et, éventuellement, tout ou partie de la couche intermédiaire 32 en oxyde de silicium puis une phase 25 de libération du substrat 31 à l'aide, par exemple, d'une attaque chimique sélective.

Le procédé 11 illustré en trait simple à la figure 12 permet, dans une même chambre de gravage, deux types distincts de gravage. On peut également s'apercevoir que le gravage oblique de l'étape 21 autorise un angle largement plus ouvert et une direction de gravure sensiblement rectiligne qui évitent d'être limités par les paramètres d'un gravage ionique réactif profond du type « Bosch » et d'utiliser ce dernier, lors de l'étape 17, selon ses paramètres optimisés de gravure verticale.

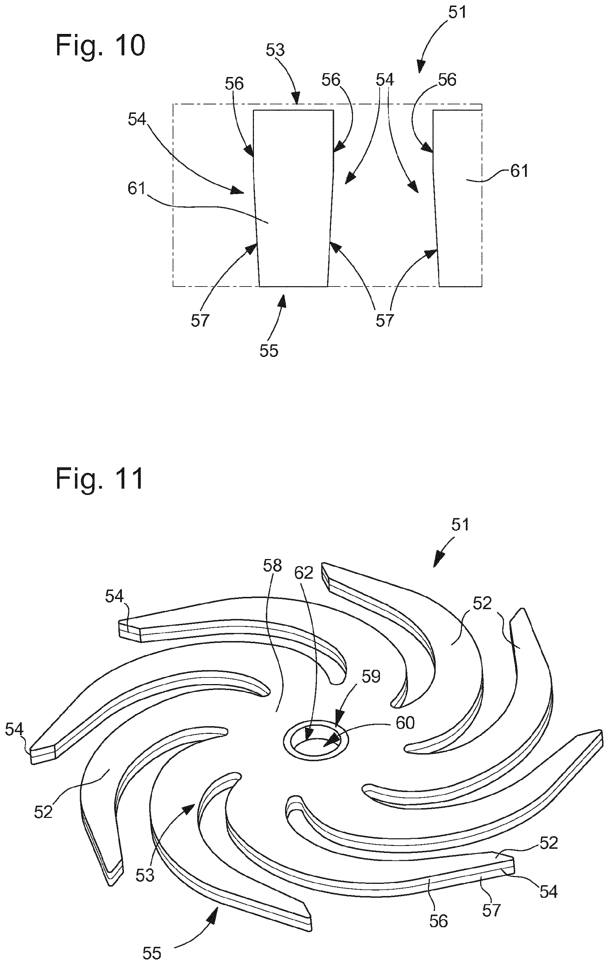

Avantageusement selon l'invention, la pièce de micromécanique 51 formant une roue dans l'exemple de la figure 11 comporte une paroi périphérique 54 formant une denture qui comporte une surface de contact réduite.

Comme mieux visible à la figure 10 qui est une vue agrandie sur une partie de la pièce 51, la pièce de micromécanique 51 comporte ainsi un corps 61 à base de silicium dont la paroi périphérique 54 borde une surface supérieure horizontale 53 et une inférieure horizontale 55 et comporte une première surface 56 sensiblement verticale et une deuxième surface 57 oblique.

On comprend donc que la deuxième surface oblique 57 sensiblement rectiligne apporte à la paroi périphérique 54 formant denture, une diminution de la surface de contact permettant une amélioration quant à sa tribologie contre une autre pièce. On comprend également que la paroi interne 60 peut également recevoir plus facilement un organe.

Bien entendu, la présente invention ne se limite pas à l'exemple illustré mais est susceptible de diverses variantes et modifications qui apparaîtront à l'homme de l'art. En particulier, une étape d'oxydation 22 destinée à lisser les parois en silicium peut être exécutée entre les étapes 21 et 23.

De plus, une partie en métal ou en alliage métallique pourrait être déposée dans la gravure 41, lors d'une étape optionnelle entre les phases 24 et 25, de sorte à former une chemise 59 dans un trou 60 de la pièce de micromécanique 51 comme illustré à la figure 11.

Cette partie en métal ou en alliage métallique pourrait même déborder au-dessus de la gravure 41 afin de former un niveau fonctionnel supplémentaire de la pièce de micromécanique composite 51 uniquement formé en métal.

Ainsi, après l'étape 24 désoxydant le substrat 31, le procédé 11, pourrait se poursuivre avec une étape destinée à remplir sélectivement une cavité formée lors des gravages 17 et 21, d'un métal ou d'un alliage métallique afin d'offrir une attache à la pièce de micromécanique.

A titre d'exemple, préférentiellement, la couche inférieure 34 du substrat 31 pourrait alors être fortement dopée et utilisée comme base directe ou indirecte pour un remplissage par galvanoplastie. Ainsi, une première phase pourrait être destinée à former un moule, par exemple en résine photosensible, sur le dessus du masque 33 et dans une partie de la gravure 41. Une deuxième phase pourrait consister à électroformer une partie métallique, à partir de la couche inférieure 34, au moins entre la pièce de micromécanique en silicium et une partie du moule formé dans la gravure 41. Enfin, une troisième phase pourrait consister à retirer le moule formé lors de la première phase. Le procédé se finirait avec la phase 25 de libération de la pièce de micromécanique composite du substrat 31 par une attaque chimique sélective.

Avantageusement selon l'invention, on comprend alors que le dépôt galvanique 59 est, par les formes de la première surface sensiblement verticale 56 et une deuxième surface oblique 57, plus difficile à retirer qu'avec une surface essentiellement verticale et bénéficie d'une meilleure résistance au cisaillement.

De plus, ladite au moins une cavité 60 qui est au moins partiellement remplie d'un métal ou d'un alliage métallique 59 permet d'offrir une attache à la pièce de micromécanique composite 51. Ainsi, dans l'exemple de la figure 11, la cavité 60 pourrait laisser un évidement cylindrique 62 apte à permettre le chassage de la pièce de micromécanique composite 51 sur un arbre avec une bonne résistance mécanique lors du dudgeonnage de la partie en métal ou en alliage métallique 59 grâce aux formes de la paroi périphérique 54.

Enfin, la pièce de micromécanique 51 ne saurait se limiter à l'application d'une roue comme visible à la figure 11. Ainsi, la pièce de micromécanique 51 peut former tout ou partie d'un organe de mouvement ou d'habillage d'une pièce d'horlogerie.

A titre d'exemples nullement limitatifs, la pièce de micromécanique 51 peut ainsi former tout ou partie d'un spiral, d'une cheville, d'un balancier, d'un axe, d'un plateau, d'une ancre comme une tige, une baguette, une fourchette, une palette et un dard, d'un mobile comme une roue, un arbre et un pignon, d'un pont, d'une platine, d'une masse oscillante, d'une tige de remontoir, d'un coussinet, d'un boîtier comme la carrure et les cornes, d'un cadran, d'un réhaut, d'une lunette, d'un poussoir, d'une couronne, d'un fond de boîtier, d'une aiguille, d'un bracelet comme un maillon, d'un décor, d'une applique, d'une glace, d'un fermoir, d'un pied de cadran, d'une tige de couronne ou d'une tige de poussoir.

## Revendications

1. Procédé (11) de fabrication d'une pièce de micromécanique (51) à base de silicium comportant les étapes suivantes :
a) se munir d'un substrat (30) à base de silicium ;
b) former un masque (33) muni d'ajourages (35) sur une partie horizontale du substrat (30) ;
c) graver, dans une chambre de gravage, selon des parois (36) sensiblement verticales, dans une partie de l'épaisseur du substrat (30), à partir d'ajourages (35) du masque (33), afin de former une paroi périphérique (54) formant denture comportant une surface de contact réduite de la pièce de micromécanique (51) ;
d) former une couche (42) de protection uniquement sur les parois (36) verticales en laissant le fond (38) de gravure (39) de l'étape c) sans couche de protection ;
e) graver, dans la chambre de gravage, selon des parois (37) obliques prédéterminées, dans le reste de l'épaisseur du substrat (30) à partir du fond (38) sans couche de protection afin de former des surfaces inférieures (57) obliques sous la paroi périphérique (54) de la pièce de micromécanique de manière à ce que chaque surface inférieure (57) oblique de la paroi périphérique (54) forme avec une surface verticale (56) de cette paroi (54) un angle supérieur à 10° et inférieur à 45° et de préférence compris entre 20 et 40°;
f) libérer la pièce de micromécanique (51) du masque (33) et du substrat (30), et
en ce que l'étape e) est réalisée en mélangeant du gaz de gravage et du gaz de passivation dans la chambre de gravage afin de former des parois (37) obliques et lors de cette étape e), les flux continus des gaz de gravage et de passivation sont pulsés afin de favoriser le gravage en fond de cavité.

2. Procédé selon la revendication précédente, **caractérisé en ce que** l'étape c) est réalisée en alternant un flux de gaz de gravage et un flux de gaz de passivation dans la chambre de gravage afin de former des parois (36) sensiblement verticales.

3. Procédé selon la revendication 1 ou 2, **caractérisé en ce que** l'étape d) comporte les phases suivantes :
d1) oxyder la gravure (39) obtenue lors de l'étape c) pour former la couche (42) de protection en oxyde de silicium ;
d2) graver de manière directionnelle la couche (42) de protection afin de retirer sélectivement la partie de couche (42) de protection uniquement au niveau du fond (38) de la gravure (39) de l'étape c).

4. Pièce de micromécanique (51) pouvant être obtenue à partir du procédé selon l'une des revendications précédentes, la pièce comportant un corps (61) à base de silicium dont la paroi périphérique (54) formant denture comporte une première surface (56) sensiblement verticale suivie d'une deuxième surface (57) oblique, lesdites première et deuxième surfaces (56, 57) permettant de diminuer la surface de contact de ladite denture de la paroi périphérique (54) et étant comprises entre des surfaces supérieure et inférieure horizontales (53, 55) de la pièce,
**caractérisée en ce que**
ladite surface verticale (56) et ladite surface oblique (57) forment un angle supérieur à 10° et inférieur à 45° et de préférence compris entre 20 et 40°.

5. Pièce de micromécanique (51) selon la revendication précédente, **caractérisée en ce qu'**elle comporte, en outre, au moins une cavité (60) comportant une paroi interne comprenant également une première surface (56) sensiblement verticale et une deuxième surface (57) sensiblement oblique.

6. Pièce de micromécanique (51) selon la revendication 4 ou 5, **caractérisé en ce qu'**elle forme tout ou partie d'un organe de mouvement ou d'habillage d'une pièce d'horlogerie.

## Patentansprüche

1. Verfahren (11) zum Herstellen eines mikromechanischen Teils (51) auf Siliziumbasis, das die folgenden Schritte umfasst:
a) Bereitstellen eines Substrats (30) auf Siliziumbasis;
b) Gestalten einer mit Durchbrüchen (35) versehenen Maske (33) auf einem horizontalen Abschnitt des Substrats (30);
c) Ätzen in einer Ätzkammer entlang im Wesentlichen vertikaler Wände (36) innerhalb eines Teils der Dicke des Substrats (30) ausgehend von Durchbrüchen (35) der Maske (33), um eine Umfangswand (54) zu bilden, die eine Verzahnung bildet, die eine reduzierte Kontaktfläche des mikromechanischen Teils (51) aufweist;
d) Ausbilden einer Schutzschicht (42) ausschließlich auf den vertikalen Wänden (36), wobei der Boden (38) der Ätzung (39) des Schrittes c) ohne Schutzschicht belassen wird;
e) Ätzen in der Ätzkammer entlang vorgegebener schräger Wände (37) in den Rest der Dicke des Substrats (30) von dem Boden (38) ohne Schutzschicht, um schräge untere Flächen (57) unter der Umfangswand (54) des mikromechanischen Teils zu bilden, derart, dass jede schräge untere Fläche (57) der Umfangswand (54) mit einer vertikalen Fläche (56) dieser Wand (54) einen Winkel größer als 10° und kleiner als 45° und vorzugsweise zwischen 20 und 40° bildet;
f) Lösen des mikromechanischen Teils (51) von der Maske (33) und dem Substrat (30), und
wobei der Schritt e) durch Mischen von Ätzgas und Passivierungsgas in der Ätzkammer durchgeführt wird, um schräge Wände (37) zu bilden, und wobei in diesem Schritt e) die kontinuierlichen Ströme der Gase von Ätz- und Passivierungsmitteln gepulst werden, um das Ätzen am Boden des Hohlraums zu fördern.

2. Verfahren nach dem vorhergehenden Anspruch, **dadurch gekennzeichnet, dass** der Schritt c) durchgeführt wird, indem abwechselnd ein Ätzgasstrom und ein Passivierungsgasstrom in die Ätzkammer geleitet werden, um die im Wesentlichen vertikalen Wände (36) zu bilden.

3. Verfahren nach Anspruch 1 oder 2, **dadurch gekennzeichnet, dass** der Schritt d) die folgenden Phasen umfasst:
d1) Oxidieren der in Schritt c) erhaltenen Ätzung (39) zur Bildung der Schutzschicht (42) aus Siliziumoxid;
d2) gerichtetes Ätzen der Schutzschicht (42), um den Teil der Schutzschicht (42) selektiv nur am Boden (38) der Ätzung (39) von Schritt c) zu entfernen.

4. Mikromechanisches Teil (51), das nach dem Verfahren gemäß einem der vorhergehenden Ansprüche erhalten werden kann, wobei das Teil einen Körper (61) auf Siliziumbasis umfasst, dessen Umfangswand (54), die eine Verzahnung bildet, eine erste im Wesentlichen vertikale Fläche (56) aufweist, gefolgt von einer zweiten schrägen Fläche (57), wobei die erste und die zweite Fläche (56, 57) ermöglichen, die Kontaktfläche der Verzahnung der Umfangswand (54) zu verringern, und zwischen horizontalen oberen und unteren Flächen (53, 55) des Teils enthalten sind,
**dadurch gekennzeichnet, dass** die vertikale Fläche (56) und die schräge Fläche (57) einen Winkel größer als 10° und kleiner als 45° und vorzugsweise zwischen 20 und 40° bilden.

5. Mikromechanisches Teil (51) nach dem vorhergehenden Anspruch, **dadurch gekennzeichnet, dass** es außerdem mindestens einen Hohlraum (60) mit einer Innenwand aufweist, die ebenfalls eine erste, im Wesentlichen vertikale Fläche (56) und eine zweite, im Wesentlichen schräge Fläche (57) umfasst.

6. Mikromechanisches Teil (51) nach Anspruch 4 oder 5, **dadurch gekennzeichnet, dass** es ganz oder teilweise ein Uhrwerk- oder Ausstattungsorgan eines Zeitmessgeräts bildet.

## Claims

1. Method (11) for fabricating a silicon-based micromechanical component (51) comprising the following steps:
a) taking a silicon-based substrate (30);
b) forming a mask (33) pierced with holes (35) on a horizontal portion of the substrate (30);
c) etching, in an etching chamber, according to substantially vertical walls (36), in a part of the thickness of the substrate (30), from holes (35) of the mask (33), in order to form a peripheral wall (56) forming gearing comprising a reduced contact surface of the micromechanical component (51);
d) forming a protective layer (42) only on the vertical walls (36), leaving the bottom (38) of the etch (39) made in step c) without any protective layer;
e) etching, in the etching chamber, according to predetermined oblique walls (37), in the remaining thickness of the substrate (30) from the bottom (38), which has no protective layer, in order to form oblique lower surfaces (57) beneath the peripheral walls (56) of the micromechanical component, so that each oblique lower surface (57) of the peripheral wall (54) forms with a vertical surface (56) of this wall (54) an angle larger than 10° and smaller than 45° and preferably comprised between 20 and 40°;
f) releasing the micromechanical component (51) from the mask (33) and from the substrate (30), and
in that step e) is achieved by mixing an etching gas and a passivation gas in the etching chamber in order to form oblique walls (37), and during this step e), the continuous etching and passivation gas flows are pulsed to enhance etching of the cavity bottom.

2. Method according to the preceding claim, **characterized in that** step c) is achieved by alternating an etching gas flow and a passivation gas flow in the etching chamber in order to form substantially vertical walls (36).

3. Method according to claim 1 or 2, **characterized in that** step d) comprises the following phases:
d1) oxidizing the etch (39) obtained in step c) to form the protective silicon oxide layer (42);
d2) directionally etching the protective layer (42) in order to selectively remove only the part of the protective layer (42) on the bottom (38) of the etch (39) made in step c).

4. Micromechanical component (51) that can be obtained through the method according to one of the preceding claims, the component comprising a silicon-based body (61) whose peripheral wall (54) forming gearing comprises a substantially vertical first surface (56) followed by an oblique second surface (57), said first and second surfaces (56, 57) allowing reducing the contact surface of said gearing of the peripheral wall (54) and being comprised between horizontal higher and lower surfaces (53, 55) of the component,
**characterized in that** said vertical surface (56) and said oblique surface (57) form an angle larger than 10° and smaller than 45° and preferably comprised between 20 and 40°.

5. Micromechanical component (51) according to the preceding claim, **characterized in that** it further comprises at least one cavity (60) comprising an inner wall also comprising a substantially vertical first surface (56) and a substantially oblique second surface (57).

6. Micromechanical component (51) according to claim 4 or 5, **characterized in that** it forms all or part of a movement or external part member of a timepiece.
